# EUROPEAN PATENT APPLICATION

(11) **EP 2 076 105 A2**
(43) Date of publication of application: **01.07.2009**
(21) Application number: 08020009.0
(22) Date of filing: 17.11.2008
(51) Int. Cl.: H05K 3/34

(54) **High frequency circuit unit**

(30) Priority: 25.12.2007 JP 2007332637
(71) Applicant: Alps Electric Co., Ltd., Tokyo 145-8501 (JP)
(72) Inventor: Shiino, Hiroko, Tokyo 145-8501 (JP)
(74) Representative: Klunker . Schmitt-Nilson . Hirsch

(57) **Abstract**

A high frequency circuit unit suitable for miniaturization is provided by surely soldering a single face of a fixing leg of a cover body to a land on a circuit substrate. In the high frequency circuit unit, an electronic component (2) mounted on a component mounting face (1a) of a circuit substrate (1) is covered by a cover body(3) consisting of a metal plate, a fixing leg (6) protruded from four courses of the cover body (3) is inserted into a through-hole (4) in the circuit substrate (1), and a copper foil land (5) provided in a periphery of the through-hole (4) and the fixing leg (6) are soldered on the component mounting face (1a). The fixing leg (6) is press-molded to have a watershoot shape such that one side of front-back both faces for the becomes a convex surface (6a) and the other side becomes a concave surface(6b), and the convex surface (6a) is provided to face an outer circumference side of the circuit substrate (1) within the through-hole (4), in order to solder the convex surface (6a) of the fixing leg (6) to the copper foil land (5).

## Description

### Cross Reference to Related Applications

The present invention contains subject matter related to Japanese Patent Application JP2007-332637 filed in the Japanese Patent Office on December 25, 2007, the entire contents of which being incorporated herein by reference.

### BACKGROUND

### 1. Technical Field

The present invention relates to a high frequency circuit unit in which a component mounting face of a circuit substrate is covered by a cover body consisting of a metal plate, and particularly, relates to a fixing leg of the cover body, which is soldered to a land on the component mounting face.

### 2. Related Art

In many cases, radio communication devices use a high frequency circuit unit that is modularized by attaching a cover body (a shielding cover) consisting of a metal plate to a circuit substrate providing thereon a high frequency circuit. Generally, in the high frequency circuit unit, the cover body formed in a box shape is arranged so as to cover the component mounting face of the circuit substrate, and a plurality of fixing legs protruded from the bottom of the cover body is respectively inserted into through-holes in the circuit substrate. These through-holes are provided in the circuit substrate as circular through-holes. Since lands provided in the periphery of the through-holes and the fixing legs inserted into the through-holes are soldered on the component mounting face, the cover body is surely attached to the circuit substrate. Moreover, since the cover body is grounded when the lands are connected to a ground pattern on the circuit substrate, electronic components mounted on the component mounting face can be electromagnetically shielded by the cover body (for example, see Japanese Patent Application Laid-Open No. 1993-82953).

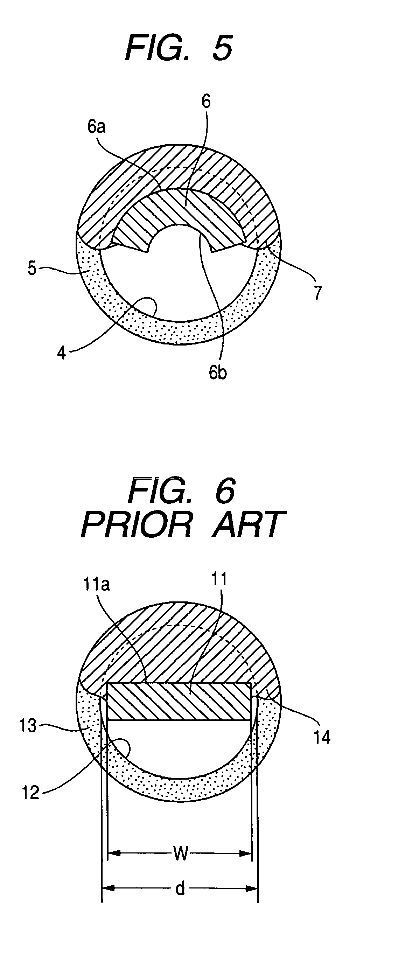

FIG. 6 is an explanation diagram illustrating a solder connecting structure for a fixing leg of a cover body in this kind of a known high frequency circuit unit. As illustrated in the present drawing, the fixing leg 11 of the cover body is formed in the shape of a flat plate, and the fixing leg 11 is inserted into a through-hole 12 that is a circular through-hole in a circuit substrate. Moreover, a copper foil land 13 is formed in the shape of a circular ring in the periphery of the opening end of the through-hole 12 in a component mounting face of the circuit substrate. The fixing leg 11 is protruded from the bottom of the cover body consisting of a metal plate. Since a backlash of the fixing leg 11 within the through-hole 12 can be restrained by setting the size w of width of the fixing leg 11 slightly smaller than the bore diameter d of the through-hole 12, the position for attaching the cover body on the circuit substrate can be prescribed with high precision. Moreover, creamy solder is previously applied on the copper foil land 13. Then, since the creamy solder is heated and melted in a reflow furnace in the state where the cover body is mounted on the circuit substrate by inserting the fixing leg 11 into the through-hole 12, the fixing leg 11 and the copper foil land 13 are mechanically and electrically connected (soldered) to each other via solder 14 obtained by solidifying the melted solder. In addition, before the creamy solder is applied on the copper foil land 13, required electronic components are previously mounted on the component mounting face of the circuit substrate.

By the way, since there is required a circuit design by which wiring patterns, electronic components, or the like are located even near the side panel of the cover body in the region, which is covered by the cover body, on the component mounting face of the circuit substrate in case of a miniaturized high frequency circuit unit, to apply the creamy solder over the perimeter of the copper foil land 13 has a greater risk of a short circuit trouble. Therefore, as illustrated in FIG. 6, the creamy solder is applied on one part (the region close to the outer circumference of the circuit substrate) of the copper foil land 13, and the solder 14 obtained by solidifying this creamy solder after heating and melting the creamy solder is mainly attached to a single face 11a of the fixing leg 11. In other words, since there is adopted a solder connecting structure in which the single face 11a of the front-back both faces of the fixing leg 11 having a flat plate shape, which is arranged toward the outer circumference side of the circuit substrate becomes a primary soldered face and the solder does not exist on the other part (the region being far from the outer circumference of the circuit substrate) of the copper foil land 13 close to the wiring patterns, the electronic components, or the like covered by the cover body, a short circuit trouble caused by accelerating the miniaturization of the high frequency circuit unit is prevented beforehand.

However, in the above-described known high frequency circuit unit as illustrated in FIG. 6, since the interval between the central portion in the width direction of the fixing leg 11 of the cover body and the inner wall of the through-hole 12 is slightly broadened, the melted solder may not be attached to the central portion in the width direction. In this case, reliability is degraded because the soldering intensity between the fixing leg 11 and the copper foil land 13 is insufficient. In other words, since the solder connecting structure in which the single face 11a of the fixing leg 11 becomes the primary soldered face can guarantee only about one-half of the solder contacting area of the fixing leg 11 compared to a solder connecting structure in which the front-back both faces of the fixing leg 11 become the soldered face, the attaching intensity of the cover body to the circuit substrate is easy to be insufficient because the contact area of the solder 14 is extremely decreased if the melted solder is not attached to the central portion in the width direction of the single face 11a.

### SUMMARY

The present invention has been achieved in view of the situation above, and it is desirable to provide a high frequency circuit unit suitable for miniaturization by surely soldering a single face of a fixing leg of a cover body to a land on a circuit substrate.

According to an aspect of the invention, there is provided a high frequency circuit unit in which an electronic component mounted on a component mounting face of a circuit substrate is covered by a cover body consisting of a metal plate, a fixing leg protruded from a bottom of the cover body is inserted into a circular through-hole provided in the circuit substrate, and a land provided in a periphery of the through-hole and the fixing leg are soldered on the component mounting face. The fixing leg is press-molded to have a shape such that one side of front-back both faces for the fixing leg becomes a convex surface and the other side becomes a concave surface, the convex surface of the fixing leg is provided to face an outer circumference side of the circuit substrate within the through-hole, and the convex surface is soldered to the land.

In the high frequency circuit unit constituted in this manner, since the interval between the convex surface of the watershoot-shaped fixing leg inserted into the circular through-hole (the through-hole) and the inner wall of the through-hole becomes narrow, melted solder can be easily and extensively attached to the convex surface of the fixing leg approaching and facing creamy solder when the creamy solder applied to only a part (the region close to the outer circumference of the circuit substrate) on the land in order to avoid a short circuit trouble is heated and melted. Moreover, since the surface area for the convex surface of the fixing leg molded in the shape of a watershoot is broadened compared to that of a single face (a flat face) of a flat plate-shaped fixing leg, it is easy to increase a solder contacting area even from this point of view. Accordingly, the single face (the convex surface) of the fixing leg of the cover body can be surely soldered to the land on the circuit substrate, and thus the attaching intensity of the cover body does not become so insufficient even though miniaturization of the high frequency circuit unit is accelerated. Furthermore, since the mechanical intensity of the watershoot-shaped fixing leg can be increased compared to that of the flat plate-shaped fixing leg by press-molding the fixing leg in the shape of a watershoot, the cover body is not so deformed.

In the above-described configuration, if a transverse sectional shape of the fixing leg is an L shape or an arc shape, the fixing leg is easily press-molded.

Moreover, in the above-described configuration, if a tip of the fixing leg of the cover body is in the through-hole in the circuit substrate, in other words, the fixing leg is not protruded from the bottom of the circuit substrate, the high frequency circuit unit that can be surface-mounted on a motherboard is obtained.

Moreover, in the above-described configuration, if the fixing leg is provided at a corner (for example, four corners) of the cover body, the cover body can be held in a stable posture by few fixing legs.

According to the high frequency circuit unit of the present invention, since the fixing leg of the cover body inserted into the circular through-hole is press-molded to have a shape such that one side of front-back both faces of the fixing leg becomes the convex surface and the other side becomes the concave surface and the convex surface of the fixing leg faces the outer circumference side of the circuit substrate within the through-hole, the convex surface of the fixing leg approaches and faces the creamy solder on the land, and thus the melted solder can be easily and extensively attached to the convex surface of the fixing leg. Moreover, since the surface area for the convex surface of the fixing leg is broadened compared to that of a flat face, it is easy to increase a solder contacting area even from this point of view. Accordingly, the single face (the convex surface) of the fixing leg of the cover body can be surely soldered to the land on the circuit substrate, and thus the attaching intensity of the cover body does not become so insufficient even though miniaturization of the high frequency circuit unit is accelerated. Moreover, the accompanied effect that the cover body is not so deformed can be also expected, because the mechanical intensity of the fixing leg is increased by press-molding the fixing leg in the shape of a watershoot.

### BRIEF DESCRIPTION OF THE DRAWINGS

FIG. 1 is a plan view illustrating a high frequency circuit unit according to a first embodiment of the present invention.
FIG. 2 is a side view illustrating the high frequency circuit unit.
FIG. 3 is a perspective view illustrating a substantial part of a fixing leg of a cover body included in the high frequency circuit unit.
FIG. 4 is an explanation diagram illustrating a solder connecting structure of the fixing leg illustrated in FIG. 3.
FIG. 5 is an explanation diagram illustrating a solder connecting structure of a fixing leg according to a second embodiment of the present invention.
FIG. 6 is an explanation diagram illustrating a solder connecting structure of a fixing leg in the related art.

### DESCRIPTION OF EXEMPLARY EMBODIMENTS

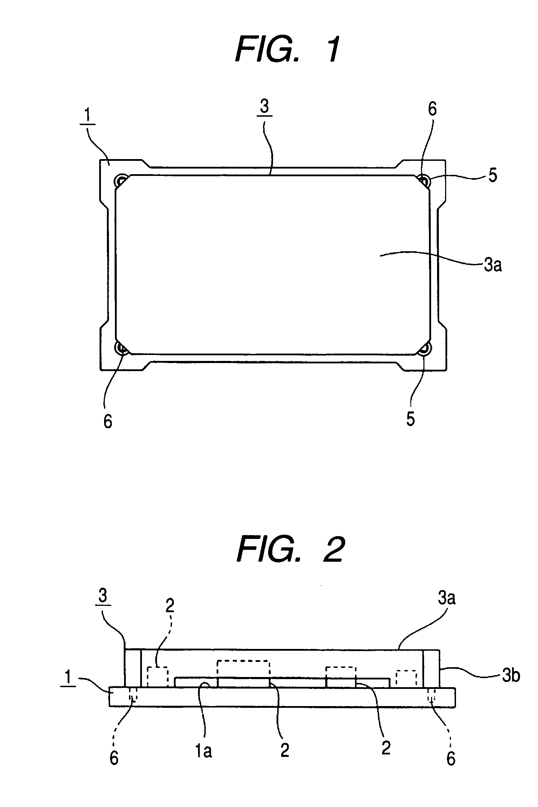

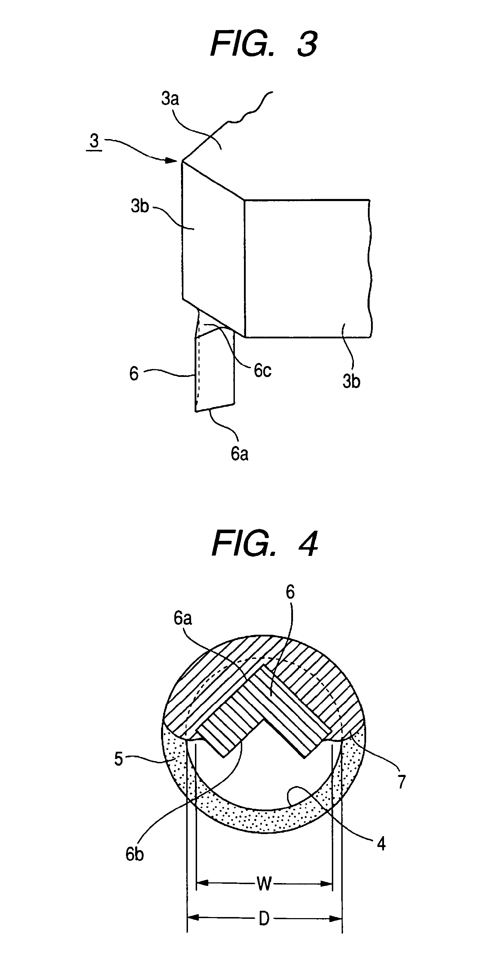

When embodiments of the present invention are described with reference to the drawings, FIG. 1 is a plan view illustrating a high frequency circuit unit according to a first embodiment of the present invention, FIG. 2 is a side view illustrating the high frequency circuit unit, FIG. 3 is a perspective view illustrating a substantial part of a fixing leg of a cover body included in the high frequency circuit unit, and FIG. 4 is an explanation diagram illustrating a solder connecting structure of the fixing leg. However, a solder is not illustrated in FIG. 1 and FIG. 2.

The high frequency circuit unit illustrated in these drawings mainly includes a substantially rectangular circuit substrate 1, various types of electronic components 2 mounted on a component mounting face 1a of the circuit substrate 1, and a box-shaped cover body 3 that covers the electronic components 2 and so on, and consists of a metal plate attached to the circuit substrate 1.

The circuit substrate 1 has a wiring pattern, a ground pattern, or the like (not illustrated) to which the electronic components 2 on the component mounting face 1a are connected, and a high frequency circuit consists of the patterns, the electronic components 2, and so on. Moreover, through-holes 4 for inserting fixing legs 6 of the cover body 3 and copper foil lands 5 for mechanically and electrically connecting the fixing legs 6 via solders 7 are provided at the places corresponding to four corners of the cover body 3 in the circuit substrate 1 (see FIG. 4). The through-holes 4 are provided in the circuit substrate 1 as circular through-holes, and the copper foil lands 5 are formed in the shape of a circular ring in the periphery of the component mounting face-side 1a opening ends of the through-holes 4. Creamy solders are applied only to a part (a region close to an outer circumference of the circuit substrate 1) on the copper foil lands 5, and the creamy solders are heated and melted in order to solder the fixing legs 6 within the through-holes 4 to the copper foil lands 5. In other words, since there is adopted a solder connecting structure in which solders are not on the other part (a region being far from the outer circumference of the circuit substrate 1) of the copper foil lands 5 close to the wiring pattern, the electronic components 2, or the like covered by the cover body 3, a short circuit trouble caused by accelerating the miniaturization of the high frequency circuit unit is prevented beforehand.

The cover body 3 is made by forming one piece of metal plate in a box shape, and is used as a shielding cover. The cover body 3 includes a top panel 3a facing the component mounting face 1a of the circuit substrate 1, a side panel 3b bent at a substantially right angle at an edge of the top panel 3a and extended along the component mounting face 1a, and the fixing legs 6 extended downward from the bottom of the side panel 3b at four corners of the cover body 3. As illustrated in FIG. 3 and FIG. 4, the fixing legs 6 are press-molded to have the watershoot shape such that one side of front-back both faces becomes a convex surface 6a and the other side becomes a concave surface 6b, and the transverse sectional shape of the fixing leg is an L shape. Moreover, the base of the fixing leg 6 becomes a triangular diaphragm 6c continuously connected to the side panel 3b. As illustrated in FIG. 1, since the convex surfaces 6a of all the fixing legs 6 located at the four corners of the cover body 3 face the outside, the convex surfaces 6a of all the fixing legs 6 face the outer circumference side of the circuit substrate 1 when each fixing leg 6 is inserted into the corresponding through-hole 4 in the circuit substrate 1.

In addition, in FIG. 4, since the size w of width of the fixing leg 6 is set to be slightly smaller than the bore diameter D of the through-hole 4, a backlash of the fixing leg 6 within the through-hole 4 can be restrained, and thus the position for attaching the cover body 3 on the circuit substrate 1 can be prescribed with high precision. Moreover, since the length of the fixing leg 6 is set so that the tip of the fixing leg 6 is in the through-hole 4 even though the fixing leg 6 is inserted into the through-hole 4, in other words, the fixing leg 6 is not protruded from the bottom of the circuit substrate 1, the high frequency circuit unit can be surface-mounted on a motherboard. Moreover, since the copper foil lands 5 are connected to the ground pattern that is not illustrated, the cover body 3 soldered to the copper foil lands 5 is attached to the circuit substrate 1 under the grounded state, and thus the electronic components 2 on the component mounting face 1a can be electromagnetically shielded by the cover body 3.

Next, the procedure for attaching the cover body 3 to the circuit substrate 1 will be described. First, required electronic components 2 are previously mounted on the component mounting face 1a of the circuit substrate 1. Then, after the creamy solder is applied to a part (a region close to the outer circumference of the circuit substrate 1) on the copper foil land 5 around the through-hole 4, the cover body 3 is arranged to cover the electronic components 2 or the like on the component mounting face 1a, and each of the fixing legs 6 is inserted into the corresponding through-hole 4. As described above, since the fixing legs 6 located at the four corners are inserted into the through-holes 4, the position for attaching the cover body 3 on the circuit substrate 1 is prescribed with high precision. Moreover, since the convex surfaces 6a of the fixing legs 6 inserted into the through-holes 4 face the outer circumference side of the circuit substrate 1, the convex surfaces 6a become primary soldered faces approaching and facing the creamy solders on the copper foil lands 5. In this state, since the creamy solders are heated and melted in a reflow furnace and thus the melted solders broadly adhere to the convex surfaces 6a of the fixing legs 6, the copper foil lands 5 and the fixing legs 6 are soldered. As a result, since the fixing legs 6 located at the four corners of the cover body 3 are fixed to the copper foil lands 5 via the solders 7, the cover body 3 is attached to the circuit substrate 1 in a stable posture and thus the high frequency circuit unit is completed.

As described above, in the high frequency circuit unit according to the present embodiment, since the interval between the convex surface 6a of the watershoot-shaped fixing leg 6 inserted into the through-hole 4 in the circuit substrate 1 and the inner wall of the through-hole 4 becomes narrow, the melted solder can be easily and extensively attached to the convex surface 6a approaching and facing the creamy solder when the creamy solder applied only to a part (a region close to the outer circumference of the circuit substrate 1) on the copper foil land 5 in order to avoid a short circuit trouble is heated and melted. Moreover, since the surface area for the convex surface 6a of the fixing leg 6 molded in the shape of a watershoot is broadened compared to that of a single face (a flat face) of a flat plate-shaped fixing leg, it is easy to increase a solder contacting area even from this point of view. Accordingly, since the single face (the convex surface 6a) of the fixing leg 6 of the cover body 3 can be surely soldered to the copper foil land 5 on the circuit substrate 1, the soldering intensity between the fixing leg 6 and the copper foil land 5 is increased, and thus the attaching intensity of the cover body 3 does not become so insufficient even though miniaturization of the high frequency circuit unit is accelerated. Furthermore, since the mechanical intensity of the fixing leg 6 that is press-molded in the shape of watershoot can be increased than that of the fixing leg 6 molded in the shape of flat plate, the cover body 3 is not so deformed.

FIG. 5 is an explanation diagram illustrating a solder connecting structure for a fixing leg according to a second embodiment of the present invention. Since components corresponding to those of FIG. 4 have the same reference numbers, the overlapped descriptions are omitted.

The second embodiment is different from the above-described first embodiment in that a fixing leg 6 of a cover body consisting of a metal plate is press-molded to have the watershoot shape in which a transverse sectional shape is an arc shape and a convex surface 6a is a half-cylinder face. Therefore, the whole of the convex surface 6a of the fixing leg 6 illustrated in FIG. 5 can be evenly approached to the inner wall of the through-hole 4. Moreover, when the convex surface 6a of the fixing leg 6 is the half-cylinder face, a surface area thereof becomes large compared to that of the flat surface. Accordingly, even in the second embodiment, since a single face (the convex surface 6a) of the fixing leg 6 can be surely soldered to the copper foil land 5 on the circuit substrate, the soldering intensity between the fixing leg 6 and the copper foil land 5 can be increased and the mechanical intensity of the fixing leg 6 can be increased.

In addition, since it is preferable if the fixing leg 6 of the cover body 3 is easily press-molded in the watershoot shape to have the convex surface 6a and the concave surface 6b, the transverse sectional shape of the fixing leg 6 is not limited to an L shape or an arc shape, and for example, the transverse sectional shape of the fixing leg 6 may be a rounded angular shape or the like. Moreover, although it is preferable that the fixing legs 6 are arranged at four corners of the box-shaped cover body 3 because the cover body 3 can be held in a stable posture by few fixing legs 6, the approximately same effect as those of the above-described embodiments is obtained even though the fixing legs 6 are provided at places other than the four corners of the cover body 3.

It should be understood by those skilled in the art that various modifications, combinations, sub-combinations and alterations may occur depending on design requirements and other factors insofar as they are within the scope of the appended claims of the equivalents thereof.

## Claims

1. A high frequency circuit unit in which an electronic component mounted on a component mounting face of a circuit substrate is covered by a cover body consisting of a metal plate, a fixing leg protruded from a bottom of the cover body is inserted into a circular through-hole provided in the circuit substrate, and a land provided in a periphery of the through-hole and the fixing leg are soldered on the component mounting face, wherein
the fixing leg is press-molded to have a shape such that one side of front-back both faces for the fixing leg becomes a convex surface and the other side becomes a concave surface, the convex surface of the fixing leg is provided to face an outer circumference side of the circuit substrate within the through-hole, and the convex surface is soldered to the land.

2. The high frequency circuit unit according to claim 1, wherein a transverse sectional shape of the fixing leg is an L shape or an arc shape.

3. The high frequency circuit unit according to claim 1 or 2, wherein a tip of the fixing leg is in the through-hole.

4. The high frequency circuit unit according to any one of claims 1 to 3, wherein the fixing leg is provided at a corner of the cover body.
